# EUROPEAN PATENT SPECIFICATION

(11) **EP 3 780 040 B1**
(45) Date of publication and mention of the grant of the patent: **19.10.2022**
(21) Application number: 18920773.1
(22) Date of filing: 19.10.2018
(51) Int. Cl.: H01F 38/26, G01R 15/18, G01R 15/06, G01R 15/16

(54) **WIDEBAND VOLTAGE TRANSFORMER**
BREITBANDIGER SPANNUNGSWANDLER
TRANSFORMATEUR DE TENSION EN BANDE LARGE

(30) Priority: 31.05.2018 CN 201810549899
(43) Date of publication of application: 17.02.2021
(73) Proprietor: Global Energy Interconnection Research Institute Co., Ltd, Beijing 102211 (CN); State Grid Corporation of China, Beijing 100031 (CN)
(72) Inventor: DONG, Wei, Beijing 102211 (CN); GAO, Chong, Beijing 102211 (CN); ZHOU, Jianhui, Beijing 102211 (CN); PANG, Hui, Beijing 102211 (CN)
(74) Representative: White, Andrew John
(86) International application number: PCT/CN2018/111058
(87) International publication number: WO 2019/227826

(56) References cited:
- EP-A1- 2 853 903
- WO-A1-2017/071333
- CN-A- 102 005 289
- CN-A- 103 187 162
- CN-A- 104 111 367
- CN-A- 104 681 261
- CN-A- 105 182 035
- CN-B- 104 111 367
- CN-U- 205 280 790
- CN-Y- 2 864 689
- DE-T5-112016 004 925

## Description

### TECHNICAL FIELD

The disclosure relates to the technical field of power systems, and in particular to a wideband voltage transformer.

### BACKGROUND

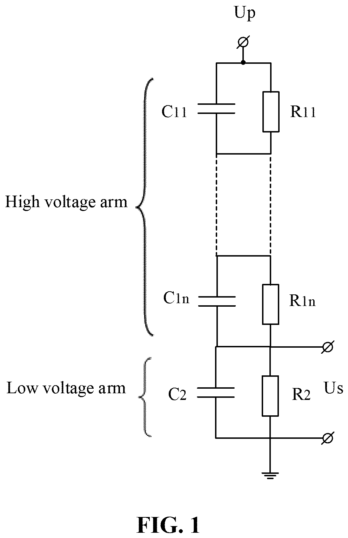

As an indispensable major device, a direct-current (DC) voltage transformer in DC power transmission systems plays an important role in electric power measurement, power quality monitoring, transmission of relay and protection signal and the like. At present, the DC voltage transformer is composed of a resistance voltage divider formed by a series of resistance elements in series connection. In order to prevent the resistance voltage divider from being affected by various transient overvoltages (including lightning overvoltages), voltage-equalizing capacitors are typically coupled/connected to the resistance voltage divider in parallel. The specific principle diagram of the DC voltage transformer is as illustrated in FIG. 1. The number of stages of the resistance voltage divider and the capacitance voltage divider vary from each other depending on different voltage classes. In FIG. 1, the lowest stage is referred to as a low voltage arm, and a plurality of stages thereon are formed into a high voltage arm. R₂ denotes a resistance of the low voltage arm, C₂ denotes a capacitance of the low voltage arm, R₁ denotes a resistance of the high voltage arm, and C₁ denotes a capacitance of the high voltage arm. R₁=R₁₁+R₁₂+...+R₁ₙ, C₁=C₁₁//C₁₂//...//C_{1n.} A primary voltage Up is acted on the top of the high voltage arm, and an output voltage Us of the low voltage arm is used to be coupled to a secondary system.

The DC voltage transformer has the defects in the following three aspects.

### 1. The primary side insulation reliability is low due to the defect in structural design.

In primary devices of DC power transmission projects, the failure rate of DC voltage transformers is relatively high, and most of them are insulation failures. The problem on primary side insulation reliability mainly includes design defect of the primary structure, selection of the resistance-capacitance element and insulation design, and the like.

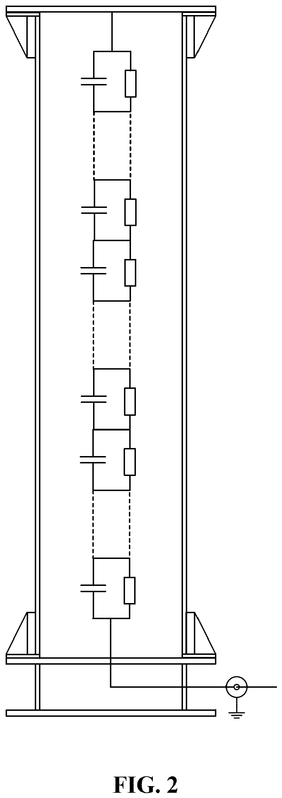

The structural design defect of the DC voltage transformer lies in: in order to meet requirements on insulation performance, the resistance voltage divider formed by resistors R₁₁, R₁₂, ..., R₁ₙ in series connection and the voltage-equalizing capacitor formed by capacitors C₁₁, C₁₂, ..., C₁ₙ in series connection are arranged in a hollow insulator, and two ends of the hollow insulator are packaged by flanges. An insulating medium is filled in the hollow insulator to meet the requirements on the insulation. The overall structural diagram of the DC voltage transformer is as illustrated in FIG. 2. The outer surface of the hollow insulator is located in an atmospheric environment and is prone to aggregation of pollutants day by day. Particularly, under the action of a DC electric field, the aggregation velocity and extent of the pollutants are more serious than in an alternating-current (AC) electric field. The dry pollutants have a low electric conductivity. During heavy fog or light rain, the pollutants aggregated on the surface of the hollow insulator are moistened and thus the electric conductivity is increased. In this case, the potential distribution outside the hollow insulator is susceptible to the degree of pollution and moistened state of the outer surface of the hollow insulator. The larger the humidity in the area, the higher the electric conductivity, and the smaller the voltage drop. The smaller the humidity in the area, the lower the electric conductivity, and the larger the voltage drop. At the meantime, since the resistance-capacitance voltage divider in the DC voltage transformer is not susceptible to the external pollutants, the potential distribution from an upper end to a lower end is in a uniform state axially. Due to the pollutants, the potential distributions of the DC voltage transformer in axial and radial directions are nonuniform and a large potential difference is caused locally. The nonuniform potential distribution will have a direct impact on the local electric field intensity, such that the distribution of electric field intensity is distorted. When such a distortion becomes serious to dissociate the air, a flashover phenomenon (i.e., a pollution flashover phenomenon) occurs on the surface of the hollow insulator. In a serious case, a breakdown fault is caused between the hollow insulator and the internal resistance-capacitance element, and thus the DC voltage transformer is damaged permanently.

### 2. The axial temperature gradient is large and the temperature rise is high, such that the measurement accuracy of DC voltage is low.

The hollow insulator of the DC voltage transformer uses a single insulator, and the insulator is composed of a composite sleeve and two metal flanges located on a top and a bottom. The composite has small specific heatcapacity and poor heat dissipation performance, and the metal flange has large specific heatcapacity and good heat dissipation performance. It is meant that the DC voltage transformer with the existing structure has poor heat dissipation performance, such that heat generated by heating elements (i.e., resistors) are gathered to the inner upper end of the hollow insulator along with the insulating medium, and the internal upper and lower ends of the hollow insulator of the DC voltage transformer have a large temperature gradient. The temperature difference may reach 50 K, 60 K or more depending on different voltage classes. Resistance elements will change in resistance at different temperatures. The larger the temperature change, the larger the resistance deviation, such that the voltage division ratio of the resistance voltage divider makes changes to cause the measurement error, thereby affecting the measurement accuracy of DC voltage. Moreover, the overhigh temperature rise will affect the working stability of the resistance and capacitance elements in the DC voltage transformer, such that the service life of the element is greatly reduced or even damaged permanently. The allowed maximum environmental temperature of the existing DC voltage transformer is 40°C.

### 3. The wideband voltage signal cannot be measured accurately as follows.

### 3-1) There is no capability of measuring high-frequency voltage signals (3-200 kHz or more).

In the topological structure of the circuit of the existing DC voltage transformer, the resistance element R1n and the capacitance element C1n on each stage of the high voltage arm are connected in parallel to form a plurality of resistance-capacitance parallel connection units; and thereafter, the resistance-capacitance parallel connection units are in series connection to form the resistance-capacitance voltage divider, thereby forming a primary body of the DC voltage transformer. The topological structure is called a resistance-capacitance parallel connection topological structure. The DC voltage transformer using the resistance-capacitance parallel connection topological structure may measure DC voltage signals and low-frequency AC voltage signals (within 3 kHz) but fails to measure high-frequency voltage signals.

For the purpose of implementing ultra-high-speed protection for a flexible DC power grid, compared with conventional DC projects, the flexible DC power grid system requires that voltage and current transformers have a cut-off frequency of 200 kHz or more and response time of less than 25 µs. To accurately measure the voltage change ratio and the amplitude is crucial for the flexible DC power grid to implement quick, reliable and accurate protection. The voltage transformer with a wide measurement range, a quick transmission characteristic and low delay time can measure rated parameters and fault parameters of the system within a wide range, has the correct measurement accuracy and the low delay characteristic, and can accurately measure a wave traveling process upon the occurrence of fault. According to the national standard (GB/T 26217-2010), the cut-off frequency (-3 dB) of the DC voltage transformer is merely 3 kHz, and the response time is 250 µs. The above frequency characteristic cannot meet the requirements of quick protection on the flexible DC power grid.

### 3-1) The measurement accuracy of the low-frequency voltage signal (0 Hz to 3 kHz) is low.

Because of the existence of stray capacitance between the high voltage arm of the DC voltage transformer and the ambient grounded body or electrified body, the stray capacitance current flows out of or into the high voltage arm under the action of a high voltage to cause a voltage measurement error. Such an error is referred to as the additional error. The additional error increases with the increase of the voltage class.

The capacitance voltage transformer (CVT) in AC power grids reduces the impact of the stray capacitance on the measurement accuracy by significantly increasing the capacitance. However, the DC voltage transformer has different principles and different requirements on electrical performance with the AC voltage transformer, such that the capacitance cannot be allowed to be too large to result in the large measurement error (the error may reach 30%) of the low-frequency voltage signal. As a consequence, the DC voltage transformer cannot be used to accurately measure the low-frequency voltage signals in the DC power grid, and even cannot be applied to voltage measurement and protection of the AC power grid.

The voltage signal output from the low voltage arm of the existing DC voltage transformer is transmitted to a control room through a cable, and the control room may be hundreds of meters towards the DC voltage transformer. The stray capacitance also exists between the cable and the earth or the ambient grounded body. The longer the distance of the cable, the larger the stray capacitance, and the larger the measurement error of the voltage.

Related technologies are known from WO 2017/071333 A1, CN 104111367 B and EP 2853903 A1.

### SUMMARY

An objective of embodiments of the disclosure is to provide a wideband voltage transformer, so as to at least solve the problems of low primary side insulation reliability, low voltage measurement accuracy and uncapable of measuring of a wideband voltage signal.

The features of a wideband voltage transformer according to the present disclosure are defined in the independent claims, and the preferable features according to the present invention are defined in the dependent claims.

The wideband voltage transformer provided by the embodiments of the disclosure includes the hollow insulator, the metal flanges, the fixed flanges, the resistance-capacitance voltage-equalizing assembly, and the resistance-capacitance hybrid connection voltage divider. The metal flanges are mounted on the two ends of the hollow insulator, the fixed flanges are mounted on the inner walls of the metal flanges, and the two ends of the resistance-capacitance voltage-equalizing assembly are respectively connected to the fixed flanges. The two ends of the resistance-capacitance hybrid connection voltage divider are respectively connected to the primary system and a secondary system through the metal flanges, such that the wideband voltage transformer has high primary side insulation reliability and high voltage measurement accuracy, and can implement accurate measurement of a wideband voltage signal.

In the embodiments of the disclosure, compared with the related art, the number of metal flanges are increased by 2N-2 (the N represents the number of hollow insulators). The more the number of the hollow insulators, the more the number of metal flanges. The specific heat capacity of the material of which the metal flange is made is far greater than that of the material of which the hollow insulator is made. The increased number of hollow insulators is helpful to dissipate the heat quickly, lower the temperature rise in the voltage transformer and reduce the resistance deviation of the resistors, thereby improving the measurement accuracy of a DC voltage, remarkably expanding a service temperature range (-40°C to +70°C) of the voltage transformer product, and improving the operation reliability of the wideband voltage transformer.

The wideband voltage transformer provided by the embodiments of the disclosure not only has a capability of measuring DC voltage signals, low-frequency voltage signals and the high-frequency voltage signals, but also significantly reduces the resistance deviation of the resistors, and has the measurement bandwidth reaching 2 MHz or more, the measurement accuracy of the DC voltage reaching the class 0.1 and the response time of less than 25 µs.

The wideband voltage transformer provided by the embodiments of the disclosure significantly lowers the internal temperature rise; compared with the DC voltage transformer in the related art, the temperature rise is lowered by 50% or more.

The service ambient temperature range of the wideband voltage transformer provided by the embodiments of the disclosure is expanded to -40°C to +70°C compared with the DC voltage transformer in the related art.

The wideband voltage transformer provided by the embodiments of the disclosure obviously reduces the potential difference between the hollow insulator and the resistance-capacitance voltage divider in a radial direction (horizontal direction), improves the local electric field distribution of the hollow insulator, effectively avoids the flashover on the outside surface of the hollow insulator and the breakdown failure between the hollow insulator and the internal resistance-capacitance hybrid connection voltage divider and the resistance-capacitance voltage-equalizing assembly, significantly improves the pollution resistance grade of the wideband voltage transformer, and improves the primary side insulation reliability.

In the embodiments of the disclosure, since the resistance-capacitance hybrid connection voltage divider is in a perfect shielded state, the additional error is reduced to the greatest extent, and both the measurement accuracy of the DC voltage and the measurement accuracy of the wideband voltage signal are improved.

In embodiments of the disclosure, the secondary signal collecting unit and the voltage transformer are designed integrally, such that the electrical signal is converted into an optical signal, and then the optical signal is transmitted to the control room of the converter station through an optical cable. Since the optical signal is not affected by the stray capacitance, the high measurement accuracy of the wideband voltage transformer is further ensured.

In embodiments of the disclosure, the number of secondary voltage division units is increased. The plurality of secondary voltage division units are in parallel connection, and include an end connected to a low-voltage arm of the resistance-capacitance hybrid connection voltage divider and another end connected to the signal collecting units.

In embodiments of the disclosure, the number of signal collectors is consistent with the number of secondary voltage division units, and the signal collectors are in one-to-one correspondence with the secondary voltage division units. Each path of signal collector is powered independently and works independently, such that normal transmission of signals on other paths is not affected in case of failure or damage on any path of secondary voltage division unit or signal collector, thereby ensuring the operation reliability of the wideband voltage transformer.

The wideband voltage transformer provided by the embodiments of the disclosure is applied to AC systems, and may also be applied to DC systems.

The wideband voltage transformer provided by the embodiments of the disclosure has a variety of applications, specifically including DC power transmission projects, AC power transmission/distribution projects, power grids of high-speed railways and any fields and occasions having requirements for measuring wideband voltage signals.

### BRIEF DESCRIPTION OF THE DRAWINGS

FIG. 1 is a principle diagram of a DC voltage transformer in the related art.
FIG. 2 is an overall structural diagram of a DC voltage transformer in the related art.
FIG. 3 is a structural diagram of a resistance-capacitance hybrid connection voltage divider in an embodiment of the disclosure.
FIG. 4 is a structural diagram of a resistance-capacitance voltage-equalizing assembly in an embodiment of the disclosure.
FIG. 5 is a structural diagram of a wideband voltage transformer in an embodiment of the disclosure.
FIG. 6 is a structural diagram of a signal collecting module in an embodiment of the disclosure.

In the figures, 1-metal flange, 2-hollow insulator, 3-resistance-capacitance voltage-equalizing assembly, 4-fixed flange, 5-resistance-capacitance hybrid connection voltage divider, 6-insulating medium, 7-base, and 8-signal collecting module.

### DETAILED DESCRIPTION

The disclosure is further described below in detail in combination with the accompanying drawings.

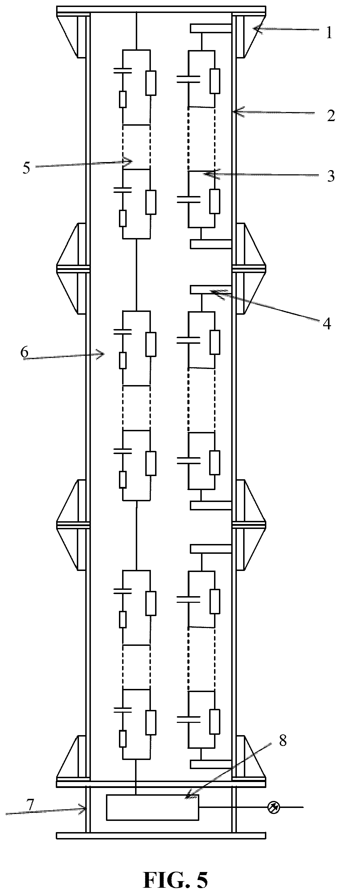

An embodiment of the disclosure provides a wideband voltage transformer. The specific structure is as illustrated in FIG. 5, and may include a hollow insulator 2, metal flanges 1, fixed flanges 4, a resistance-capacitance voltage-equalizing assembly 3, a resistance-capacitance hybrid connection voltage divider 5, a base 7 and a signal collecting module 8.

The metal flanges 1 are mounted on two ends of the hollow insulator 2; the metal flange on a top end of the hollow insulator 2 is connected to a primary system, and the metal flange on a bottom end of the hollow insulator 2 is connected to the base 7. The fixed flanges 4 are mounted on inner walls of the metal flanges 1, and two ends of the resistance-capacitance voltage-equalizing assembly 3 are respectively connected to the fixed flanges 4. Two ends of the resistance-capacitance hybrid connection voltage divider 5 are respectively connected to the primary system and the signal collecting module 8 through the metal flanges 1. The signal collecting module 8 and the base 7 are designed overall and mounted on a bottom of the wideband voltage transformer.

One hollow insulator 2 may be provided, or at least two hollow insulators 2 may also be provided; and the details are as follows.
1. When one hollow insulator 2 is provided, the metal flanges 1 are mounted on the two ends of the hollow insulator 2 (two metal flanges in total); the fixed flanges 4 are mounted on the inner walls of the metal flanges 1 (i.e., two fixed flanges 4 are provided), the two ends of the resistance-capacitance voltage-equalizing assembly 3 are respectively connected to the fixed flanges 4, and the two ends of the resistance-capacitance hybrid connection voltage divider 5 are respectively connected to the primary system and the signal collecting module 8 through the metal flanges 1.
2. When at least two hollow insulators 2 are provided, the at least two hollow insulators are sequentially in series connection, the metal flanges are mounted on two ends of each hollow insulator 1, the fixed flanges 4 are mounted on the inner walls of the metal flanges 1, and the two ends of the resistance-capacitance voltage-equalizing assembly 3 are respectively connected to the fixed flanges 4.

In an embodiment of the disclosure, an end of the resistance-capacitance hybrid connection voltage divider 5 is connected to the primary system through the metal flange 1 on a top end of a first hollow insulator, and the other end of the resistance-capacitance hybrid connection voltage divider 5 is connected to the signal collecting module 8 through the metal flange 1 on a bottom end of a last hollow insulator.

In an optional embodiment of the disclosure, the resistance-capacitance voltage-equalizing assembly 3 and the resistance-capacitance hybrid connection voltage divider 5 are sealed in the hollow insulator 2 through sealing rings located on end surfaces of the metal flanges 1.

In an optional embodiment of the disclosure, the specific number of hollow insulators 2 is determined by a requirement of a voltage class of a working condition; and an insulating medium 6 is filled between the resistance-capacitance hybrid connection voltage divider 5 and the resistance-capacitance voltage-equalizing assembly 3 as well as between the resistance-capacitance hybrid connection voltage divider 5 and the fixed flanges 4, so as to keep good insulation between the resistance-capacitance hybrid connection voltage divider 5, the resistance-capacitance voltage-equalizing assembly 3 and the fixed flanges 4. As an example, the insulating medium 6 may use insulating oil or insulating gas.

In an optional embodiment of the disclosure, the number of resistance-capacitance voltage-equalizing assemblies 3 in the hollow insulator 2 is specifically divided into the following two cases.
1. If an actual working condition requires that a measurement accuracy of the wideband voltage transformer is class 0.2, one resistance-capacitance voltage-equalizing assembly 3 is disposed in each hollow insulator 2.
2. If the actual working condition requires that the measurement accuracy of the wideband voltage transformer is higher than the class 0.2, two or more resistance-capacitance voltage-equalizing assemblies 3 are disposed in each hollow insulator 2, and the resistance-capacitance voltage-equalizing assemblies 3 are in parallel connection between the fixed flanges 4.

The case where the measurement accuracy of the wideband voltage transformer is the class 0.2 indicates that the voltage error of the wideband voltage transformer is plus or minus 0.2%.

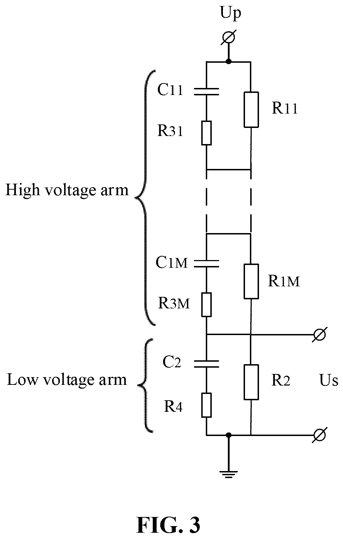

In an optional embodiment of the disclosure, the structural diagram of the resistance-capacitance hybrid connection voltage divider 5 is as illustrated in FIG. 3. In FIG. 3, the lowest stage is referred to as a low voltage arm, a plurality of stages thereon are formed into a high voltage arm, the low voltage arm includes R₂, C₂ and R₄, the high voltage arm specifically includes R₁, C₁ and R₃, the R₁ includes measurement resistance elements R₁₁, R₁₂, ..., R_{1M}, the C₁includes resistance-capacitance elements C₁₁, C₁₂, ..., C_{1M}, and the R₃ includes damping resistance elements R₃₁, R₃₂, .., R_{3M}. R1=R₁₁+R₁₂+...+R_{1M}, C₁=C₁₁//C₁₂//...//C_{1M}, R3=R₃₁+R₃₂+...+R_{3M}. A primary voltage Up is acted on the high voltage arm, and an output voltage Us of the low voltage arm is transmitted to the signal collecting module 8.

The resistance-capacitance hybrid connection voltage divider 5 includes M resistance-capacitance hybrid connection units that are in series connection sequentially. The resistance-capacitance hybrid connection unit includes a measurement capacitance element, a damping resistance element and a measurement resistance element. The measurement capacitance element is in parallel connection with the measurement resistance element after being in series connection with the damping resistance element.

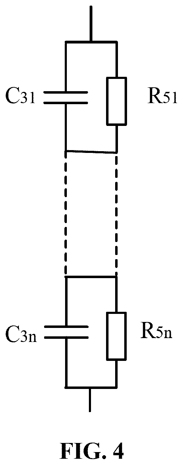

In an embodiment of the disclosure, the structural diagram of the resistance-capacitance voltage-equalizing assembly 3 is as illustrated in FIG. 4. In FIG. 4, the C₃₁, C₃₂, ..., C₃ₙ are all voltage-equalizing capacitance elements, and the R₅₁, R₅₂, ..., R₅ₙ are all voltage-equalizing resistance elements. The resistance-capacitance voltage-equalizing assembly 3 includes n resistance-capacitance voltage-equalizing units. The resistance-capacitance voltage-equalizing unit includes a voltage-equalizing resistance element and a voltage-equalizing capacitance element in parallel connection.

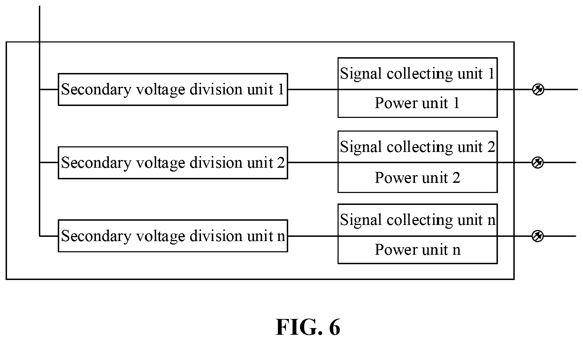

In an embodiment of the disclosure, the signal collecting module includes a case, a secondary voltage division unit, a signal collecting unit and a power unit that are located in the case. As illustrated in FIG. 6, an input end of the secondary voltage division unit is connected to a bottom end of the resistance-capacitance hybrid connection voltage divider, an output end of the secondary voltage division unit is connected to an input end of the signal collecting unit, and an output end of the signal collecting unit is connected to a control room of a converter station through an optical fiber.

An end of the power unit is connected to a power end of the signal collecting unit, and the other end of the power unit is connected to a power source of the converter station. The number of power units is equal to the number of signal collecting units, that is, each power unit independently supplies the power to the corresponding signal collecting unit.

In an embodiment of the disclosure, each of the resistance-capacitance hybrid connection voltage divider and the secondary voltage division unit includes a plurality of resistance-capacitance hybrid connection units that are in series connection sequentially.

In an embodiment of the disclosure, the resistance-capacitance hybrid connection unit includes a measurement capacitance element, a damping resistance element and a measurement resistance element. The measurement capacitance element is in parallel connection with the measurement resistance element after being in series connection with the damping resistance element.

In an embodiment of the disclosure, one or at least two secondary voltage division units are provided. Each secondary voltage division unit is independently designed. In case of damage or abnormality of any one secondary voltage division unit or multiple secondary voltage division units, the normal work of other secondary voltage division units is not affected.

In an embodiment of the disclosure, when at least two secondary voltage division units are provided, the at least two secondary voltage division units are in parallel connection. An input end of each secondary voltage division unit is connected to a bottom end of the resistance-capacitance hybrid connection voltage divider, and an output end of each secondary voltage division unit is connected to the input end of the signal collecting unit.

In an optional embodiment of the disclosure, the signal collecting unit includes one or at least two signal collectors. Each signal collector is powered independently. The signal output of each signal collector does not affect to each other.

In an optional embodiment of the disclosure, when the signal collecting unit includes at least two signal collectors, the at least two signal collectors are in parallel connection. An input end of each signal collector is connected to the secondary voltage division unit, and an output end of each signal collector is connected to the control room of the converter station.

In an optional embodiment of the disclosure, one or at least two power units are provided. When at least two power units are provided, each power unit supplies power to each signal collector. The power unit works independently and is wired independently. Each power unit does not interfere with each other. In case of damage or abnormality of any power unit, normal work of other power units is not affected.

In an optional embodiment of the disclosure, the signal collecting unit and the base are designed integrally, and the signal collecting unit is arranged in the base 7 or close to the base 7.

In an optional embodiment of the disclosure, a voltage range of an input votlage signal of the signal collecting unit is at least 3 times of a rated input signal.

The wideband voltage transformer with high accuracy, fast response, high reliability and no site check provided by the embodiments of the disclosure are mainly based on the following three technologies.

### 1. Wideband voltage measurement technology

According to a wave traveling theory and a wave impedance matching technology, the disclosure provides the resistance-capacitance hybrid connection voltage divider 5 as illustrated in FIG. 3. The resistance-capacitance hybrid connection voltage divider 5 includes M resistance-capacitance hybrid connection units that are in series connection sequentially. The resistance-capacitance hybrid connection unit includes a measurement capacitance element, a damping resistance element and a measurement resistance element. The measurement capacitance element is in parallel connection with the measurement resistance element after being in series connection with the damping resistance element. The voltage transformer using the resistance-capacitance hybrid connection voltage divider 5 has the capability of measuring DC voltage signals, low-frequency AC voltage signals and high-frequency voltage signals, so as to implement wideband and fast measurement of the voltage signals. The measurement bandwidth may reach 2 MHz or more, the response time is less than 25 µs, and the application fields and application occasions of voltage transformers are expanded (the voltage transformer may be applied to conventional DC power transmission projects, flexible DC power transmission projects, AC power transmission/distribution projects, power grids of high-speed railways and any fields and occasions having measurement requirements on the wideband voltage signals).

### 2. Multi-stage resistance-capacitance voltage-equalizing technology

In the embodiments of the disclosure, the resistance-capacitance voltage-equalizing assembly 3 in a multi-stage cascaded mode is adopted. The resistance-capacitance voltage-equalizing assembly 3 includes n (n is a positive integer) resistance-capacitance voltage-equalizing units, and each resistance-capacitance voltage-equalizing unit includes a voltage-equalizing resistance element and a voltage-equalizing capacitance element in parallel connection. Multiple hollow insulators in series connection are used to replace the existing single hollow insulator, the resistance-capacitance voltage-equalizing units are mounted in each hollow insulator in parallel connection, and two ends of each resistance-capacitance voltage-equalizing unit are respectively connected to the fixed flanges 4 on two ends of the corresponding hollow insulator. The resistance-capacitance voltage-equalizing units in parallel connection in each hollow insulator are also in series connection from top to bottom, and are sealed in the hollow insulator with the resistance-capacitance hybrid connection voltage divider 5. The resistance-capacitance voltage-equalizing unit is not electrically connected to the resistance-capacitance hybrid connection voltage divider 5 in the same hollow insulator. Since the resistance-capacitance voltage-equalizing assembly 3 is packaged in the hollow insulator and is not affected by the external polluted environment, the resistance element therein may clamp the DC potential of the hollow insulator in an axial direction (vertical direction), and the hollow insulator has uniform potential distribution in the axial direction. With the adoption of the resistance-capacitance voltage-equalizing assembly 3 in the multi-stage cascaded mode, the potential difference between the hollow insulator and the resistance-capacitance hybrid connection voltage divider 5 in a radial direction (horizontal direction) is reduced, the local electric field distribution of the hollow insulator is improved, the flashover on the outside surface of the hollow insulator and the breakdown failure between the hollow insulator, the internal resistance-capacitance voltage divider and resistance-capacitance voltage-equalizing assembly are effectively avoided, and the pollution resistance grade of the wideband voltage transformer is improved.

In the embodiments of the disclosure, by the use of the multi-stage cascaded technology, multiple short hollow insulators are used to replace the single long hollow insulator. Compared with the related art, the number of metal flanges are increased by 2N-2 (the N represents the number of hollow insulators), that is, 2N metal flanges are provided. The more the number of the hollow insulators, the more the number of metal flanges. The specific heat capacity of the material of which the metal flange is made is far greater than that of the material of which the hollow insulator is made. The increased number of hollow insulators is helpful to dissipate the heat quickly, lower the temperature rise in the voltage transformer and reduce the resistance deviation of the resistor, thereby improving the measurement accuracy of a DC voltage, remarkably expanding a service temperature range (-40°C to +70°C) of the voltage transformer product, and improving the operation reliability of the wideband voltage transformer.

### 3. Additional error reduction technology

Because of the existacne of stray capacitances between the high voltage arm of the DC voltage transformer and the ambient grounded body or electrified body, the stray capacitance current flows out of or into the high voltage arm under the action of low-frequency and high-frequency AC voltages to cause a measurement error in voltage. Such an error is referred to as the additional error. The additional error is increased with the increase of the voltage class.

In the embodiments of the disclosure, the resistance-capacitance voltage-equalizing assembly 3 in the multi-stage cascaded mode is adopted. The resistance-capacitance voltage-equalizing assembly is connected to two ends of each hollow insulator in parallel. The resistance-capacitance voltage-equalizing assembly 3 includes n resistance-capacitance voltage-equalizing units, and each resistance-capacitance voltage-equalizing unit includes a voltage-equalizing resistance element and a voltage-equalizing capacitance element in parallel connection. The voltage-equalizing resistance element is configured to uniformly distribute the axial power potential of the hollow insulator of the voltage transformer. The voltage-equalizing capacitance element has two functions: (1) it prevents the voltage-equalizing resistance element from being affected by various transient overvoltages (including the lightning overvoltage) to damage the voltage-equalizing resistance element; and (2) the voltage-equalizing capacitance element may block the current to flow out of or into the resistance-capacitance voltage-equalizing assembly through the stay capacitance. No electrical connection is formed between the resistance-capacitance hybrid connection voltage divider 5 and the resistance-capacitance voltage-equalizing assembly 3. Both the capacitive current to the ground and the leakage current on the surface of the hollow insulator are provided by the resistance-capacitance voltage-equalizing assembly 3 and do not pass through the resistance-capacitance hybrid connection voltage divider 5, such that the resistance-capacitance hybrid connection voltage divider 5 is in a perfect shielded state, thereby reducing the additional error to the greatest extent, and ensuring the high accuracy of measurement on low-frequency and high-frequency AC voltage signals.

In the embodiments of the disclosure, since the signal collecting unit and the voltage transformer are designed integrally, the electrical signal of the existing voltage transformer is converted into an optical signal at the low voltage side, and the optical signal is transmitted to the control room at a long distance through an optical cable. By means of the technology, the interference of the additional error due to the fact that the electrical signal is interfered by the stay capacitance when transmitted through the cable is solved thoroughly, the additional error is further reduced, and the measurement accuracy on the voltage signals is improved.

The above is only the specific implementation manner of the disclosure and not intended to limit the scope of protection of the disclosure. The scope of protection of the disclosure shall be subjected to the scope of protection of the claims.

## Claims

1. A wideband voltage transformer, comprising:
a hollow insulator (2), metal flanges (1), fixed flanges (4), a resistance-capacitance voltage-equalizing assembly (3), a resistance-capacitance hybrid connection voltage divider (5), a base (7) and a signal collecting module (8);
wherein the metal flanges (1) are mounted on two ends of the hollow insulator (2), the metal flange (1) on a top end of the hollow insulator (2) is connected to a primary system, and the metal flange (1) on a bottom end of the hollow insulator (2) is connected to the base (7);
the fixed flanges (4) are mounted on inner walls of the metal flanges (1), and two ends of the resistance-capacitance voltage-equalizing assembly (3) are respectively connected to the fixed flanges (4); and
a top end of the resistance-capacitance hybrid connection voltage divider (5) is connected to the primary system, and a bottom end of the resistance-capacitance hybrid connection voltage divider (5) is connected to the signal collecting module (8);
wherein the resistance-capacitance hybrid connection voltage divider (5) comprises M resistance-capacitance hybrid connection units that are in series connection; wherein each resistance-capacitance hybrid connection unit comprises a measurement capacitance element, a damping resistance element and a measurement resistance element; and the measurement capacitance element being in series connection with the damping resistance element is in parallel connection with the measurement resistance element;
wherein the resistance-capacitance voltage-equalizing assembly (3) comprises n resistance-capacitance voltage-equalizing units; wherein each resistance-capacitance voltage-equalizing unit comprises a voltage-equalizing resistance element and a voltage-equalizing capacitance element in parallel connection;
no electrical connection is formed between the resistance-capacitance hybrid connection voltage divider (5) and the resistance-capacitance voltage-equalizing assembly (3);
wherein one or at least two hollow insulators (2) are provided;
wherein N hollow insulators (2) are in series connection and N is greater than or equal to 2, the metal flanges (1) are mounted on two ends of each hollow insulator (2) and a number of the metal flanges (1) is 2N, and two ends of the resistance-capacitance voltage-equalizing assembly (3) are respectively connected to the fixed flanges (4); and wherein an end of the resistance-capacitance hybrid connection voltage divider (5) is connected to the primary system through the metal flange (1) on a top end of a first hollow insulator, and another end of the resistance-capacitance hybrid connection voltage divider (5) is connected to the signal collecting module (8) through the metal flange (1) on a bottom end of a last hollow insulator;
wherein the signal collecting module (8) comprises a case, and a secondary voltage division unit, a signal collecting unit and a power unit that are located in the case;
an input end of the secondary voltage division unit is connected to a bottom end of the resistance-capacitance hybrid connection voltage divider (5), an output end of the secondary voltage division unit is connected to an input end of the signal collecting unit, and an output end of the signal collecting unit is connected to a control room of a converter station through an optical fiber; and
an end of the power unit is connected to a power end of the signal collecting unit, and another end of the power unit is connected to a power source of the converter station;
wherein the secondary voltage division unit comprises a plurality of the resistance-capacitance hybrid connection units that are in series connection.

2. The wideband voltage transformer of claim 1, wherein the resistance-capacitance voltage-equalizing assembly (3) and the resistance-capacitance hybrid connection voltage divider (5) are sealed in the hollow insulator (2) through sealing rings located on end surfaces of the metal flanges (1).

3. The wideband voltage transformer of claim 1, wherein an insulating medium is filled between the resistance-capacitance hybrid connection voltage divider (5) and the resistance-capacitance voltage-equalizing assembly (3) as well as between the resistance-capacitance hybrid connection voltage divider (5) and the fixed flanges (4), and the insulating medium is insulating oil or insulating gas.

4. The wideband voltage transformer of claim 1, wherein a number of hollow insulators (2) is determined by means of a requirement of a voltage class of a working condition.

5. The wideband voltage transformer of claim 1, wherein in response to an actual working condition requiring that a measurement accuracy of the wideband voltage transformer is class 0.2, one resistance-capacitance voltage-equalizing assembly (3) is disposed in each hollow insulator (2); and
in response to the actual working condition requiring that the measurement accuracy of the wideband voltage transformer is higher than the class 0.2, two or more resistance-capacitance voltage-equalizing assemblies are disposed in each hollow insulator (2), and the resistance-capacitance voltage-equalizing assemblies are in parallel connection between the fixed flanges (4).

6. The wideband voltage transformer of claim 1, wherein one or at least two secondary voltage division units are provided; wherein in response to at least two secondary voltage division units, the at least two secondary voltage division units are in parallel connection; an input end of each secondary voltage division unit is connected to a bottom end of the resistance-capacitance hybrid connection voltage divider (5), and an output end of each secondary voltage division unit is connected to the input end of the signal collecting unit.

7. The wideband voltage transformer of claim 1, wherein the signal collecting unit comprises one or at least two signal collectors; wherein in response to the signal collecting unit comprising at least two signal collectors, the at least two signal collectors are in parallel connection, an input end of each signal collector is connected to the secondary voltage division unit, and an output end of each signal collector is connected to the control room of the converter station.

8. The wideband voltage transformer of claim 7, wherein one or at least two power units are provided; wherein in response to at least two power units, each power unit supplies power to each signal collector.

9. The wideband voltage transformer of claim 1, wherein the signal collecting unit and the base (7) are designed integrally, and the signal collecting unit is arranged in the base (7) or close to the base (7).

10. The wideband voltage transformer of claim 1, wherein a voltage range of an input voltage signal of the signal collecting unit is at least 3 times of a rated input signal.

## Patentansprüche

1. Ein Breitbandspannungswandler, der Folgendes umfasst:
einen Hohlisolator (2), Metallflansche (1), Festflansche (4), eine Widerstands-Kapazitäts-Potenzialausgleichsanordnung (3), einen Widerstands-Kapazitäts-Hybridverbindungs-Spannungsteiler (5), eine Basis (7) und ein Signalerfassungsmodul (8);
wobei die Metallflansche (1) auf zwei Enden des Hohlisolators (2) montiert sind, wobei der Metallflansch (1) auf einem oberen Ende des Hohlisolators (2) mit einem Primärsystem verbunden ist und der Metallflansch (1) auf einem unteren Ende des Hohlisolators (2) mit der Basis (7) verbunden ist;
wobei die Festflansche (4) auf Innenwänden der Metallflansche (1) montiert sind und zwei Enden der Widerstands-Kapazitäts-Potenzialausgleichsanordnung (3) jeweils mit den Festflanschen (4) verbunden sind; und
wobei ein oberes Ende des Widerstands-Kapazitäts-Hybridverbindungs-Spannungsteilers (5) mit dem Primärsystem verbunden ist und ein unteres Ende des Widerstands-Kapazitäts-Hybridverbindungs-Spannungsteilers (5) mit dem Signalerfassungsmodul (8) verbunden ist;
wobei der Widerstands-Kapazitäts-Hybridverbindungs-Spannungsteiler (5) M Widerstands-Kapazitäts-Hybridverbindungseinheiten umfasst, die in Reihenschaltung sind; wobei jede Widerstands-Kapazitäts-Hybridverbindungseinheit ein Messkapazitätselement, ein Dämpfungswiderstandselement und ein Messwiderstandselement umfasst; und das Messkapazitätselement, das in Reihenschaltung mit dem Dämpfungswiderstandselement ist, in Parallelschaltung mit dem Messwiderstandselement ist;
wobei die Widerstands-Kapazitäts-Potenzialausgleichsanordnung (3) n Widerstands-Kapazitäts-Potenzialausgleichseinheiten umfasst; wobei jede Widerstands-Kapazitäts-Potenzialausgleichseinheit ein Potenzialausgleichs-Widerstandselement und ein Potenzialausgleichs-Kapazitätselement in Parallelschaltung umfasst;
wobei keine elektrische Verbindung zwischen dem Widerstands-Kapazitäts-Hybridverbindungs-Spannungsteiler (5) und der Widerstands-Kapazitäts-Potenzialausgleichsanordnung (3) gebildet ist;
wobei ein oder mindestens zwei Hohlisolatoren (2) bereitgestellt sind;
wobei N Hohlisolatoren (2) in Serienschaltung sind und N größer als oder gleich 2 ist, die Metallflansche (1) auf zwei Enden von jedem Hohlisolator (2) montiert sind und eine Zahl der Metallflansche (1) 2N ist, und zwei Enden der Widerstands-Kapazitäts-Potenzialausgleichsanordnung (3) jeweils mit den Festflanschen (4) verbunden sind; und wobei ein Ende des Widerstands-Kapazitäts-Hybridverbindungs-Spannungsteilers (5) mit dem Primärsystem über den Metallflansch (1) auf einem oberen Ende eines ersten Hohlisolators verbunden ist und ein anderes Ende des Widerstands-Kapazitäts-Hybridverbindungs-Spannungsteilers (5) mit dem Signalerfassungsmodul (8) über den Metallflansch (1) auf einem unteren Ende eines letzten Hohlisolators verbunden ist;
wobei das Signalerfassungsmodul (8) ein Gehäuse und eine Sekundärspannungsteilungseinheit, eine Signalerfassungseinheit und eine Stromversorgungseinheit, die sich in dem Gehäuse befindet, umfasst;
wobei ein Eingangsende der Sekundärspannungsteilungseinheit mit einem unteren Ende des Widerstands-Kapazitäts-Hybridverbindungs-Spannungsteilers (5) verbunden ist, ein Ausgangsende der Sekundärspannungsteilungseinheit mit einem Eingangsende der Signalerfassungseinheit verbunden ist und ein Ausgangsende der Signalerfassungseinheit mit einem Steuerraum einer Umformerstation über einen Lichtwellenleiter verbunden ist; und
wobei ein Ende der Stromversorgungseinheit mit einem Stromversorgungsende der Signalerfassungseinheit verbunden ist und ein anderes Ende der Stromversorgungseinheit mit einer Stromversorgungsquelle der Umformerstation verbunden ist;
wobei die Sekundärspannungsteilungseinheit eine Vielzahl von Widerstands-Kapazitäts-Hybridverbindungseinheiten umfasst, die in Serienschaltung sind.

2. Der Breitbandspannungswandler nach Anspruch 1, wobei die Widerstands-Kapazitäts-Potenzialausgleichsanordnung (3) und der Widerstands-Kapazitäts-Hybridverbindungs-Spannungsteiler (5) in dem Hohlisolator (2) über Dichtungsringe, die sich auf Endflächen der Metallflansche (1) befinden, abgedichtet sind.

3. Der Breitbandspannungswandler nach Anspruch 1, wobei ein Isoliermedium zwischen dem Widerstands-Kapazitäts-Hybridverbindungs-Spannungsteiler (5) und der Widerstands-Kapazitäts-Potenzialausgleichsanordnung (3) sowie zwischen dem Widerstands-Kapazitäts-Hybridverbindungs-Spannungsteiler(5) und den Festflanschen (4) gefüllt ist und das Isoliermedium Isolieröl oder Isoliergas ist.

4. Der Breitbandspannungswandler nach Anspruch 1, wobei eine Zahl von Hohlisolatoren (2) mittels eines Erfordernisses einer Spannungsklasse einer Arbeitsbedingung bestimmt wird.

5. Der Breitbandspannungswandler nach Anspruch 1, wobei als Reaktion darauf, dass eine tatsächliche Arbeitsbedingung erfordert, dass eine Messgenauigkeit des Breitbandspannungswandlers Klasse 0,2 ist, eine Widerstands-Kapazitäts-Potenzialausgleichsanordnung (3) in jedem Hohlisolator (2) angeordnet ist; und
als Reaktion darauf, dass die tatsächliche Arbeitsbedingung erfordert, dass die Messgenauigkeit des Breitbandspannungswandlers höher als die Klasse 0,2 ist, zwei oder mehr Widerstands-Kapazitäts-Potenzialausgleichsanordnungen in jedem Hohlisolator (2) angeordnet sind und die Widerstands-Kapazitäts-Potenzialausgleichsanordnungen in Parallelschaltung zwischen den Festflanschen (4) sind.

6. Der Breitbandspannungswandler nach Anspruch 1, wobei eine oder mindestens zwei Sekundärspannungsteilungseinheiten bereitgestellt sind; wobei als Reaktion auf mindestens zwei Sekundärspannungsteilungseinheiten die mindestens zwei Sekundärspannungsteilungseinheiten in Parallelschaltung sind; ein Eingangsende von jeder Sekundärspannungsteilungseinheit mit einem unteren Ende des Widerstands-Kapazitäts-Hybridverbindungs-Spannungsteilers (5) verbunden ist und ein Ausgangsende von jeder Sekundärspannungsteilungseinheit mit dem Eingangsende der Signalerfassungseinheit verbunden ist.

7. Der Breitbandspannungswandler nach Anspruch 1, wobei die Signalerfassungseinheit einen oder mindestens zwei Signalerfasser umfasst; wobei als Reaktion darauf, dass die Signalerfassungseinheit mindestens zwei Signalerfasser umfasst, die mindestens zwei Signalerfasser in Parallelschaltung sind, ein Eingangsende von jedem Signalerfasser mit der Sekundärspannungsteilungseinheit verbunden ist und ein Ausgangsende von jedem Signalerfasser mit dem Steuerraum der Umformerstation verbunden ist.

8. Der Breitbandspannungswandler nach Anspruch 7, wobei eine oder mindestens zwei Stromversorgungseinheiten bereitgestellt sind; wobei als Reaktion auf mindestens zwei Stromversorgungseinheiten jede Stromversorgungseinheit an jeden Signalerfasser Strom liefert.

9. Der Breitbandspannungswandler nach Anspruch 1, wobei die Signalerfassungseinheit und die Basis (7) integral konstruiert sind und die Signalerfassungseinheit in der Basis (7) oder nahe der Basis (7) eingerichtet ist.

10. Der Breitbandspannungswandler nach Anspruch 1, wobei ein Spannungsbereich eines Eingangsspannungssignals der Signalerfassungseinheit mindestens das 3-Fache eines Nenneingangssignals ist.

## Revendications

1. Transformateur de tension à large bande, comprenant :
un isolateur creux (2), des brides métalliques (1), des brides fixes (4), un ensemble d'égalisation de tension à résistance-capacité (3), un diviseur de tension à connexion hybride à résistance-capacité (5), une base (7) et un module de collecte de signaux (8) ;
dans lequel les brides métalliques (1) sont montées sur deux extrémités de l'isolateur creux (2), la bride métallique (1) sur une extrémité supérieure de l'isolateur creux (2) est connectée à un système primaire, et la bride métallique (1) sur une extrémité inférieure de l'isolateur creux (2) est connectée à la base (7) ;
les brides fixes (4) sont montées sur des parois intérieures des brides métalliques (1), et deux extrémités de l'ensemble d'égalisation de tension à résistance-capacité (3) sont respectivement connectées aux brides fixes (4) ; et
une extrémité supérieure du diviseur de tension à connexion hybride à résistance-capacité (5) est connectée au système primaire, et une extrémité inférieure du diviseur de tension à connexion hybride à résistance-capacité (5) est connectée au module de collecte de signaux (8) ;
dans lequel le diviseur de tension à connexion hybride à résistance-capacité (5) comprend M unités de connexion hybride à résistance-capacité qui sont montées en série ; dans lequel chaque unité de connexion hybride à résistance-capacité comprend un élément de capacité de mesure, un élément de résistance d'amortissement et un élément de résistance de mesure ; et l'élément de capacité de mesure qui est monté série avec l'élément de résistance d'amortissement est monté en parallèle avec l'élément de résistance de mesure ;
dans lequel l'ensemble d'égalisation de tension à résistance-capacité (3) comprend n unités d'égalisation de tension à résistance-capacité ; dans lequel chaque unité d'égalisation de tension à résistance-capacité comprend un élément de résistance d'égalisation de tension et un élément de capacité d'égalisation de tension montés en parallèle ;
aucune connexion électrique n'est formée entre le diviseur de tension à connexion hybride à résistance-capacité (5) et l'ensemble d'égalisation de tension à résistance-capacité (3) ;
dans lequel un ou au moins deux isolateurs creux (2) sont prévus ;
dans lequel N isolateurs creux (2) sont montés en série et N est supérieur ou égal à 2, les brides métalliques (1) sont montées sur deux extrémités de chaque isolateur creux (2) et un nombre des brides métalliques (1) est 2N, et deux extrémités de l'ensemble d'égalisation de tension à résistance-capacité (3) sont respectivement connectées aux brides fixes (4) ; et dans lequel une extrémité du diviseur de tension à connexion hybride à résistance-capacité (5) est connectée au système primaire par le biais de la bride métallique (1) sur une extrémité supérieure d'un premier isolateur creux, et une autre extrémité du diviseur de tension à connexion hybride à résistance-capacité (5) est connectée au module de collecte de signaux (8) par le biais de la bride métallique (1) sur une extrémité inférieure d'un dernier isolateur creux ;
dans lequel le module de collecte de signaux (8) comprend un boîtier, et une unité de division de tension secondaire, une unité de collecte de signaux et une unité d'alimentation qui sont situées dans le boîtier ;
une extrémité d'entrée de l'unité de division de tension secondaire est connectée à une extrémité inférieure du diviseur de tension à connexion hybride à résistance-capacité (5), une extrémité de sortie de l'unité de division de tension secondaire est connectée à une extrémité d'entrée de l'unité de collecte de signaux, et une extrémité de sortie de l'unité de collecte de signaux est connectée à une salle de commande d'une station de conversion par le biais d'une fibre optique ; et
une extrémité de l'unité d'alimentation est connectée à une extrémité d'alimentation de l'unité de collecte de signaux, et une autre extrémité de l'unité d'alimentation est connectée à une source d'alimentation de la station de conversion ;
dans lequel l'unité de division de tension secondaire comprend une pluralité des unités de connexion hybride à résistance-capacité qui sont montées en série.

2. Transformateur de tension à large bande selon la revendication 1, dans lequel l'ensemble d'égalisation de tension à résistance-capacité (3) et le diviseur de tension à connexion hybride à résistance-capacité (5) sont scellés dans l'isolateur creux (2) par des bagues d'étanchéité situées sur des surfaces d'extrémité des brides métalliques (1) .

3. Transformateur de tension à large bande selon la revendication 1, dans lequel un milieu isolant est placé entre le diviseur de tension à connexion hybride à résistance-capacité (5) et l'ensemble d'égalisation de tension à résistance-capacité (3) ainsi qu'entre le diviseur de tension à connexion hybride à résistance-capacité (5) et les brides fixes (4), et le milieu isolant est une huile isolante ou un gaz isolant.

4. Transformateur de tension à large bande selon la revendication 1, dans lequel un nombre d'isolateurs creux (2) est déterminé en fonction d'une exigence d'une classe de tension d'une condition de fonctionnement.

5. Transformateur de tension à large bande selon la revendication 1, dans lequel, en réponse à une condition de fonctionnement réelle exigeant qu'une précision de mesure du transformateur de tension à large bande soit de classe 0,2, un ensemble d'égalisation de tension à résistance-capacité (3) est disposé dans chaque isolateur creux (2) ; et
en réponse à la condition de fonctionnement réelle exigeant que la précision de mesure du transformateur de tension à large bande soit supérieure à la classe 0,2, deux ensembles d'égalisation de tension à résistance-capacité ou plus sont disposés dans chaque isolateur creux (2), et les ensembles d'égalisation de tension à résistance-capacité sont montés en parallèle entre les brides fixes (4).

6. Transformateur de tension à large bande selon la revendication 1, dans lequel une ou au moins deux unités de division de tension secondaire sont prévues ; dans lequel, en réponse à au moins deux unités de division de tension secondaire, les au moins deux unités de division de tension secondaire sont montées en parallèle ; une extrémité d'entrée de chaque unité de division de tension secondaire est connectée à une extrémité inférieure du diviseur de tension à connexion hybride à résistance-capacité (5), et une extrémité de sortie de chaque unité de division de tension secondaire est connectée à l'extrémité d'entrée de l'unité de collecte de signaux.

7. Transformateur de tension à large bande selon la revendication 1, dans lequel l'unité de collecte de signaux comprend un ou au moins deux collecteurs de signaux ; dans lequel, en réponse à l'unité de collecte de signaux comprenant au moins deux collecteurs de signaux, les au moins deux collecteurs de signaux sont montés en parallèle, une extrémité d'entrée de chaque collecteur de signaux est connectée à l'unité de division de tension secondaire, et une extrémité de sortie de chaque collecteur de signaux est connectée à la salle de commande de la station de conversion.

8. Transformateur de tension à large bande selon la revendication 7, dans lequel une ou au moins deux unités d'alimentation sont fournies ; dans lequel, en réponse à au moins deux unités d'alimentation, chaque unité d'alimentation fournit de l'énergie à chaque collecteur de signaux.

9. Transformateur de tension à large bande selon la revendication 1, dans lequel l'unité de collecte de signaux et la base (7) sont conçues de manière solidaire, et l'unité de collecte de signaux est disposée dans la base (7) ou à proximité de la base (7).

10. Transformateur de tension à large bande selon la revendication 1, dans lequel une plage de tension d'un signal de tension d'entrée de l'unité de collecte de signaux est au moins 3 fois supérieure à un signal d'entrée nominal.
